(19) **Europäisches Patentamt / European Patent Office / Office européen des brevets**

(11) **EP 2 997 657 B1**

(12) **FASCICULE DE BREVET EUROPEEN**

(45) Date de publication et mention de la délivrance du brevet:
**22.11.2017 Bulletin 2017/47**

(21) Numéro de dépôt: **14725157.3**

(22) Date de dépôt: **19.05.2014**

(51) Int Cl.:
*H03K 3/64* *(2006.01)*  *H03K 4/02* *(2006.01)*
*H03M 1/66* *(2006.01)*

(86) Numéro de dépôt international:
**PCT/EP2014/060249**

(87) Numéro de publication internationale:
**WO 2014/184388 (20.11.2014 Gazette 2014/47)**

(54) **SYSTEME DE GENERATION D'UN SIGNAL ANALOGIQUE**

SYSTEM ZUR ERZEUGUNG EINES ANALOGEN SIGNALS

SYSTEM FOR GENERATING AN ANALOGUE SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.05.2013 FR 1301142**

(43) Date de publication de la demande:
**23.03.2016 Bulletin 2016/12**

(73) Titulaires:
- **THALES**
  **92400 Courbevoie (FR)**
- **Centre National de la Recherche Scientifique**
  **75794 Paris Cedex 16 (FR)**
- **Institut Polytechnique de Bordeaux**
  **33400 Talence (FR)**
- **Université de Bordeaux**
  **33000 Bordeaux (FR)**

(72) Inventeurs:
- **GARREC, Patrick**
  **F-33700 Merignac (FR)**
- **MONTIGNY, Richard**
  **F-33600 Pessac (FR)**
- **REGIMBAL, Nicolas**
  **F-33702 Merignac (FR)**
- **DEVAL, Yann**
  **F-33800 Bordeaux (FR)**
- **RIVET, François**
  **F-33400 Talence (FR)**

(74) Mandataire: **Priori, Enrico**
**Marks & Clerk France**
**Conseils en Propriété Industrielle**
**Immeuble «Visium»**
**22, avenue Aristide Briand**
**94117 Arcueil Cedex (FR)**

(56) Documents cités:
WO-A1-98/00923     US-A1- 2005 083 219
US-A1- 2006 145 902     US-A1- 2009 206 676

- **Djordje Babic ET AL: "BLOCK-BASED METHODS FOR SAMPLING RATE ALTERATION FOR ARBITRARY RATIO", TELFOR2000, 31 décembre 2000 (2000-12-31), XP055108577, Extrait de l'Internet: URL:http://www.telfor.rs/telfor2000/radovi /7-8.pdf [extrait le 2014-03-18]**

**Description**

La présente invention concerne un système de génération d'un signal analogique à partir des différents paramètres. D'une manière non limitative, cette invention est utilisable dans les domaines des télécommunications, des radars, des sonars et plus généralement de tous équipements électroniques par exemple instrumentation médicale, bancs de test ou de mesures.

Dans l'état de la technique il est connu des systèmes pour lesquels les signaux analogiques sont prédéterminés au moment de la conception du système (dans ce cas les paramètres des signaux sont fixes). Il est aussi connu des systèmes pour lesquels les signaux analogiques sont générés à la demande (dans ce cas les paramètres sont envoyés en temps réel au système).

Dans le cas des signaux prédéterminés, il est connu les systèmes suivants :

- des systèmes de génération de signaux analogiques utilisant des fonctions basiques de type rampes ou logarithmes. Ces fonctions basiques sont obtenues, par exemple, en utilisant la tension électrique de coude d'une ou plusieurs diodes.
- des systèmes comportant des filtres à ondes de surface (connu aussi sous l'acronyme anglais de « SAW » pour Surface Acoustic Waves filters), ces filtres sont suivis d'une transposition en fréquence.
- des systèmes constitués d'un ensemble d'oscillateurs commutés.

Cependant ces solutions ne sont pas souples et ne permettent pas de modifier les paramètres du signal qui est généré. De plus, dans le cas d'utilisation d'oscillateurs commutés, les interférences entre les oscillateurs dégradent la pureté spectrale du signal généré.

Pour la génération de signaux qui ont une forme prédéterminée mais dont les paramètres peuvent évoluer, il est connu d'utiliser les systèmes suivants :

- un système comportant un oscillateur contrôlé en tension électrique, connu aussi sous l'acronyme anglais de « VCO » pour Voltage Controlled Oscillator. Cet oscillateur peut être suivi d'une boucle à verrouillage de phase, connue aussi sous l'acronyme anglais de « PLL » pour Phase Locked Loop.
- un système comportant un compteur, une mémoire et un convertisseur digital/analogique, le tout suivi d'une transposition de fréquence.

Cependant ces systèmes sont limités, car la bande d'étalement des fréquences et la fréquence centrale du signal qui est généré, doivent être dans un intervalle borné.

Tous ces dispositifs peuvent être intégrés dans un circuit programmable spécialisé, connu aussi sous l'acronyme anglais de « DDS » pour Directe Digital Synthesizer ou synthétiseur digital direct en français.

Pour des signaux non connus à l'avance et nécessitant d'être générés à la demande et dans un temps très court, il est connu les systèmes suivants :

- des systèmes à mémoire de fréquence radio numérique (connus aussi sous l'acronyme « DRFM » pour Digital Radio Frequency Memory), qui permettent de mémoriser un signal analogique et de reconstituer et réémettre ce signal enregistré. Ces systèmes sont en particulier utilisés dans des radars pour la génération de signaux leurrant les autres radars. Cependant ces systèmes ne peuvent générer des signaux qu'avec une dynamique faible, en effet le nombre de bits de dynamique est de l'ordre de quelques bits. Cet ordre de grandeur est de l'ordre de 1 à 6 bits en fonction de la fréquence du signal à générer.
- Un convertisseur Sigma/Delta, ce type de convertisseur est basé sur le principe d'un suréchantillonnage du signal d'entrée. Ce système comporte ensuite un comparateur convertissant sur un bit la différence entre le signal d'entrée et le résultat de la conversion. Le résultat de la comparaison est utilisé par un filtre décimateur, qui somme les échantillons du signal d'entrée. Le convertisseur Sigma / Delta est donc un système asservi qui utilise un bouclage entrée-sortie. Ce bouclage limite la bande passante du signal pouvant être généré.

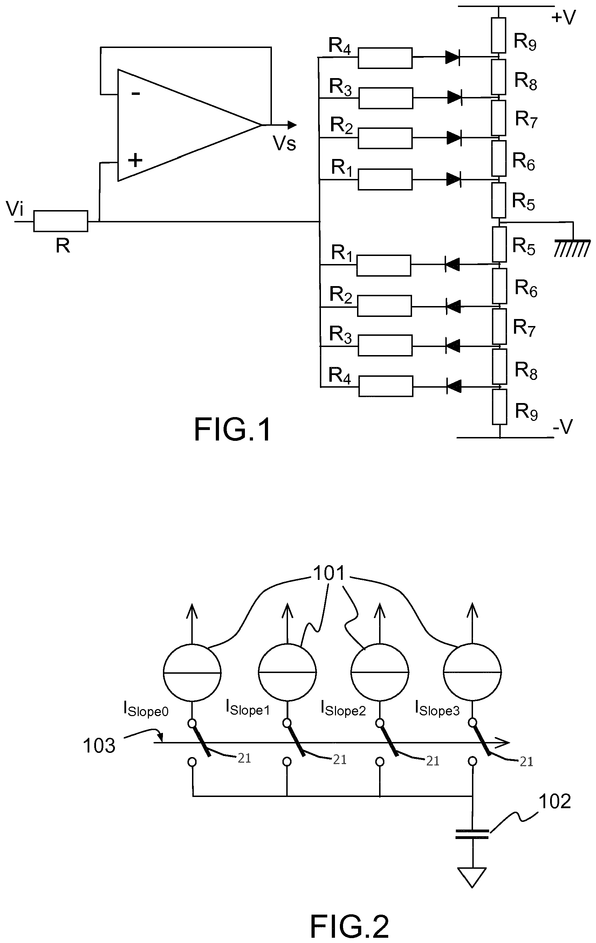

Il est aussi connu l'utilisation d'un conformateur à diodes, tel que présenté figure 1. Dans ce système, une rampe de tension électrique est envoyée aux bornes $V_i$ et va générer une onde sinusoïdale reconstruite par une sommation de trapèzes. Cependant, cette solution est limitée en fréquence car la tension électrique à générer, qui va dépendre de la dérivée de la tension électrique $V_i$ ($dV_i/_{dt}$), est limitée par la technologie de fabrication utilisée. Un exemple d'un système de génération de signaux est décrit dans la demande de brevet US 2006/145902, où on divulgue un convertisseur numérique-analogique impliquant des signaux de courant qui charge une impédance capacitive. Un but de cette invention est de proposer un système de génération de signaux qui soit totalement reconfigurable, limitant les perturbations, pouvant avoir une fréquence centrale évoluant rapidement, pouvant générer des signaux de bande d'étalement des fréquences importante et implémentable sur un circuit intégré mixte analogique/numérique. A cet effet, l'invention a pour objet un système de génération d'un signal analogique comportant :

- un ensemble d'au moins deux générateurs de courant électrique - au moins un condensateur,
- des moyens d'activation/désactivation desdits générateurs de courant électrique,
- au moins un transistor monté en parallèle du condensateur et/ou au moins un autre moyen de génération de courant électrique monté en série du condensateur, et

- des moyens de comparaison; lesdits générateurs de courant électrique étant branchés entre eux en parallèle, ledit condensateur étant branché en série avec lesdits générateurs de courant électrique, lesdits moyens d'activation/désactivation commandant lesdits générateurs de courant électrique au moyen d'un flux numérique permettant de contrôler l'intensité du courant électrique entrant dans ledit condensateur en fonction du signal à générer, et générant aux bornes dudit condensateur un signal de tension en trapèze, ledit signal analogique étant reconstitué par interpolation dudit signal en trapèze, lesdits moyens de comparaison étant adaptés pour comparer la valeur d'une tension électrique aux bornes dudit condensateur avec une valeur théorique lors du passage du signal à générer par des niveaux connus, et commander ledit transistor et/ou autre moyen de génération de courant électrique afin de modifier la valeur de cette tension électrique. Le système apporte donc les avantages suivants :

- La reconfiguration est totale grâce à une génération numérique des signaux et un temps de réponse très court.
- La génération de fréquence est effectuée par un seul générateur et les perturbations sont diminuées par rapport aux systèmes de l'état de la technique. Ainsi les perturbations radioélectriques, connues sous le nom anglais de « glitch », provoquées par commutations sont réduites, grâce à l'utilisation de bloqueurs d'ordre un. Ceci permet d'avoir une diminution des rayonnements non essentiels ou RNE.
- La vitesse d'évolution de la fréquence centrale du signal généré n'est limitée que par la vitesse de l'horloge des moyens d'activation/désactivation. Elle dépend de la technologie utilisée pour implémenter ces moyens. Ceci permet de générer un signal dont la fréquence centrale évolue depuis le continu jusqu'à l'hyperfréquence.
- La dynamique utile n'est limitée que par le compromis technologique, vitesse d'horloge et bande passante.
- Le système est en boucle ouverte, ce qui permet de générer un signal ayant une bande d'étalement des fréquences importante.
- Cette génération peut être implémentée totalement dans un seul circuit intégré mixte analogique numérique.
- Le système de l'invention a une consommation faible car les charges du condensateur sont cumulatives.
- De plus, le dispositif d'activation/désactivation des générateurs de courant électrique est de type série. Ceci permet d'avoir un bus de transfert des données étroit. Enfin afin de limiter les données échangées le système utilise un adressage relatif, basé sur l'envoi de l'augmentation ou diminution de la charge du condensateur, et de la valeur de la charge de ce condensateur.

Avantageusement les moyens d'activation/désactivation sont adaptés pour la détermination des moyens de génération de courant à activer/désactiver à partir d'une interpolation de Riemann du signal analogique à générer.

Avantageusement le système comporte en outre :

- au moins un transistor monté en parallèle du condensateur et/ou
- au moins un autre moyen de génération de courant électrique monté en série du condensateur
- et des moyens de comparaison d'une valeur d'une tension électrique aux bornes dudit condensateur avec une valeur théorique.

De plus le transistor et/ou l'autre moyen de génération étant adapté pour modifier la valeur de la tension électrique aux bornes dudit condensateur lorsqu'elle est différente de la valeur théorique.

Avantageusement le système est caractérisé en outre en ce qu'il est intégré sur une même puce ou un circuit intégré ou un circuit intégré propre à une application.

Avantageusement le système est caractérisé en outre en ce le condensateur est constitué par un condensateur d'un transistor appartenant à l'étage d'entrée d'un amplificateur de puissance

L'invention sera mieux comprise et d'autres avantages apparaîtront à la lecture de la description détaillée faite à titre d'exemple non limitatif et à l'aide des figures parmi lesquelles :

La figure 1 présente un système connu dans l'état de la technique
La figure 2 présente un premier mode de réalisation du système présenté dans l'invention
La figure 3 présente un mode de réalisation de la commande de la pente du signal analogique.
La figure 4 présente un mode de réalisation d'un dispositif de remise à zéro du système.

Le système, décrit sur la figure 2, comporte quatre générateurs de courant électrique 101. Ces générateurs de courant électrique sont branchés entre eux, en parallèle, et sont reliés à un condensateur 102, qui est donc chargé par ce condensateur. La tension électrique aux bornes du condensateur varie suivant la loi $V = \frac{1}{c} \int I dt.$ Dans cette équation, $V$ est la tension électrique (en volt) aux bornes du condensateur, $I$ est l'intensité (en ampère) du courant électrique passant par le condensateur et $C$ est la capacité (en farad) du condensateur. Le système comporte aussi des dispositifs d'activation/désactivation 103 qui permettent l'activation et la désactivation des générateurs de courant électrique 101.

Dans ce système l'intensité entrant dans le condensateur dépend du nombre de générateurs de courant électrique reliés au condensateur. Donc, la pente de l'augmentation de la tension électrique aux bornes du condensateur dépend également de ce même nombre de générateurs.

En pratique on peut se permettre de faire varier dynamiquement seulement le courant électrique pour éviter le transfert de charge dans la capacité. Il est par exemple possible de décharger le ou les condensateurs en le faisant traverser par un courant négatif.

La commande d'activation/désactivation 103 est réalisée au moyen d'un flux numérique permettant de contrôler l'intensité du courant électrique entrant dans le condensateur en fonction du signal à générer. Ce contrôle est effectué en faisant varier le nombre de générateur d'intensité qui sont activé à un instant donné. A cet effet, le flux numérique commande, via des interfaces adaptées, la fermeture ou l'ouverture de commutateurs 21 reliant chacun un générateur de courant 101 au condensateur 102. Le flux numérique, par exemple du type série, comporte un mot définissant une configuration des commutateurs.

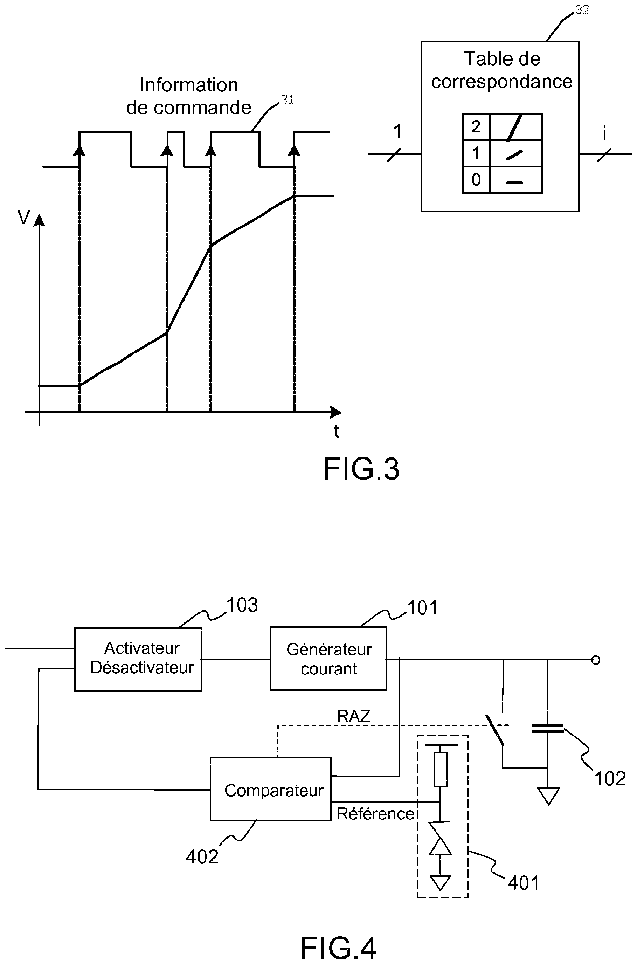

La figure 3 présente ce mode de réalisation de la commande d'activation/désactivation des générateurs de courant électrique. Plus particulièrement, elle illustre le flux numérique 31 qui est dans cet exemple de type série. Les données série sont prises en compte par une table de correspondance 32 qui présente en sortie un mot codé sur i bits, fonction des données séries d'entrée et d'un cycle d'horloge, ces i bits commandant le transfert de courant dans le condensateur 102 depuis les générateurs de courant, chaque bit activant un commutateur à la fermeture ou à l'ouverture. Dans un mode de réalisation le nombre de générateur de courant électrique est minimal et est fixé à deux. Dans ce mode de réalisation deux pentes de signes opposés, obtenues via les deux générateurs de courant électrique ayant une intensité différente, permettent de générer les signaux analogiques. De plus une commutation rapide entre les deux générateurs d'intensité permet la génération fidèle du signal analogique.

Dans un autre mode de réalisation le nombre de générateur de courant électrique est plus important. Dans ce mode de réalisation plusieurs pentes, obtenues via l'activation simultanée de plusieurs générateurs de courant électrique, via le flux numérique, ayant une intensité différente, permettent de générer les signaux analogiques. Dans ce mode de réalisation il n'est pas nécessaire de faire une commutation rapide entre les générateurs d'intensité afin de générer fidèlement le signal analogique.

Par exemple la figure 3 présente des courants différents utilisant des valeurs en puissance de 2 comme montré dans la table de correspondance.

La détermination, des différentes pentes que doit successivement suivre le signal (également appelé loi de commande), est réalisée de manière à minimiser l'écart entre :

- Le signal analogique que l'on souhaite générer
- Le signal reconstruit à partir de l'utilisation de ces différentes pentes.

Afin de réaliser cette détermination différentes méthodes d'interpolation du signal peuvent être mises en place (Riemann, Romberg, moindres carrés, polynomiales, Kalmann,...).

Dans un mode de réalisation il est possible d'utiliser une interpolation de type Riemann. Dans ce cas le signal analogique à générer est modélisé par un ensemble de trapèzes représentant l'intégrale de Riemann. Les différentes pentes des trapèzes sont fixées par la valeur des intensités que les combinaisons des différents générateurs de courant électrique peuvent délivrer. En effet les pentes de tension électrique, réalisables aux bornes du condensateur, dépendent de l'intensité du courant électrique $I_{slope}$ le traversant et de sa capacité $C_{load}$ du condensateur. Ainsi la succession des pentes de la tension électrique aux bornes du condensateur est choisie en respectant deux critères:

- ces pentes sont réalisables par le système
- ces pentes minimisent l'écart entre le signal ainsi générer et le signal que l'on souhaite générer.

La valeur de ce courant électrique est choisie numériquement parmi les valeurs possibles via un mot de commande qui contrôle l'activation/désactivation des générateurs de courant électrique. On obtient alors un bloqueur d'ordre 1, qui permet de mémoriser la valeur de la pente de la tension électrique aux bornes du condensateur. Les mots de commande peuvent être adressés par une table d'adressage, qui est préprogrammée ou calculée dynamiquement. De plus comme la commande de haute impédance est native, pour ce faire on peut déconnecter les générateurs de courant pour que la charge du condensateur reste constante, un mot de commande permettant d'annuler le courant électrique traversant le condensateur, a pour conséquence un maintien de la tension électrique aux bornes de ce dernier.

Le système, constitué de la pluralité des générateurs de courant électrique et du dispositif d'activation/désactivation, forme une pompe de charge. En effet il permet le transfert de charges entre les générateurs de courant électrique 101 et le condensateur 102. La valeur de la charge de ce condensateur dépend de la valeur du courant électrique le traversant et de la durée de cette charge. De plus dans le cas où la loi de commande est basée sur l'algorithme de Riemann, on appelle ce système pompe de Riemann.

Dans un mode de réalisation présenté figure 4 le système comporte également un dispositif de compensation du courant électrique de fuite et de remise à zéro. Ce dispositif permet d'éviter l'accumulation d'erreurs pouvant faire diverger la valeur de la charge du condensateur. Ce dispositif est asynchrone et peut être réalisé par un transistor 401 monté en parallèle du condensateur ou bien un ensemble de générateurs de courant électrique annexe. Ce système comporte aussi un dispositif 402 de comparaison d'une valeur d'une tension électrique aux bornes dudit condensateur avec une valeur théorique.

La compensation des dérives lentes est réalisée par la détection du passage du signal par des niveaux connus et référencés. Lors des passages à ces niveaux, le système compare la tension électrique par rapport à une valeur théorique et effectue les corrections pour revenir à la valeur de consigne par incréments successifs. Ainsi à chaque passage par zéro, le contenu du condensateur est remis à zéro afin d'éviter toute dérive (offset).

De même on peut corriger les erreurs de pente en modifiant la loi de commande généré par le dispositif d'activation/désactivation des générateurs de courant électrique. Si la loi de commande est optimisée les erreurs seront minimales. On peut alors prédéterminer les corrections par des extrapolations de commande.

Pour éviter les décharges de condensateurs et donc les surchauffes, on peut prendre deux condensateurs et échanger les condensateurs à chaque passage, la valeur de la charge du condensateur hors ligne est ramené à la valeur de référence par un circuit de servitude.

Dans un mode de réalisation le condensateur 102 est constitué par le condensateur d'un transistor appartenant à l'étage d'entrée d'un amplificateur de puissance. Dans ce cas le signal généré par le système présente directement une forte puissance de quelques centaines de milliwatts.

Dans un mode de réalisation le système est intégré sur une même puce, un circuit intégré ou un circuit intégré propre à une application ou « ASIC » pour Application-Specific Integrated Circuit en Anglais. Le système est intégré dans une puce de technologie adaptée aux conditions d'utilisation. Il est possible par exemple d'utiliser :

- du SiGe ou CMOS pour une production de faible coût et d'un grand nombre d'unités
- du GaN pour la rapidité, la robustesse et la possibilité d'avoir un signal de sortie de forte puissance

## Revendications

1. Système de génération d'un signal analogique comportant au moins :

    - un ensemble d'au moins deux générateurs de courant électrique (101)
    - au moins un condensateur (102),
    - des moyens d'activation/désactivation (103) desdits générateurs de courant électrique (101),
    - au moins un transistor monté en parallèle du condensateur et/ou au moins un autre moyen de génération de courant électrique monté en série du condensateur, et
    - des moyens de comparaison (402) ;

lesdits générateurs de courant électrique (101) étant branchés entre eux en parallèle, ledit condensateur (102) étant branché en série avec lesdits générateurs de courant électrique, lesdits moyens d'activation/désactivation commandant lesdits générateurs de courant électrique (101) au moyen d'un flux numérique permettant de contrôler l'intensité du courant électrique entrant dans ledit condensateur (102) en fonction du signal à générer, et générant aux bornes dudit condensateur un signal de tension en trapèze, ledit signal analogique étant reconstitué par interpolation dudit signal en trapèze, lesdits moyens de comparaison (402) étant adaptés pour comparer la valeur d'une tension électrique aux bornes dudit condensateur avec une valeur théorique (401) lors du passage du signal à générer par des niveaux connus, et commander ledit transistor et/ou autre moyen de génération de courant électrique afin de modifier la valeur de cette tension électrique.

2. Système selon la revendication 1 dans lequel générateurs de courant électrique sont configurés de manière à ce que ledit signal de tension en trapèze généré aux bornes du condensateur réalise une interpolation de type Riemann.

3. Système selon l'une des revendications 1 à 2 **caractérisé en outre en ce qu'**il est intégré sur une même puce ou un circuit intégré ou un circuit intégré propre à une application.

4. Système selon l'une des revendications 1 à 3 caractérisé en outre en ce ledit condensateur (102) est constitué par un condensateur d'un transistor appartenant à l'étage d'entrée d'un amplificateur de puissance.

## Patentansprüche

1. System zum Erzeugen eines analogen Signals, wenigstens Folgendes umfassend:

    - eine Baugruppe von wenigstens zwei elektrischen Stromgeneratoren (101);
    - wenigstens einen Kondensator (102);
    - Mittel (103) zum Aktivieren/Deaktivieren der elektrischen Stromgeneratoren (101);
    - wenigstens einen Transistor, der parallel zu dem Kondensator geschaltet ist, und/oder wenigstens ein anderes Mittel zum Erzeugen von elektrischem Strom, das in Serie mit dem Kondensator geschaltet ist, und
- Vergleichsmittel (402);

wobei die elektrischen Stromgeneratoren (101) parallel zueinander angeschlossen sind, wobei der Kondensator (102) in Serie mit den elektrischen Stromgeneratoren angeschlossen ist, wobei die Aktivierungs-/Deaktivierungsmittel die elektrischen Stromgeneratoren (101) mittels eines Bitstroms steuern, der das Regeln der Intensität des in den Kondensator (102) eintretenden elektrischen Stroms in Abhängigkeit von dem zu erzeugenden Signal zulässt und an den Anschlüssen des Kondensators ein trapezförmiges Spannungssignal erzeugt, wobei das analoge Signal durch Interpolation des trapezförmigen Signals rekonstituiert wird, wobei die Vergleichsmittel (402) zum Vergleichen des Wertes einer elektrischen Spannung an den Anschlüssen des Kondensators mit einem theoretischen Wert (401) bei der Passage des zu erzeugenden Signals durch bekannte Pegel und zum Steuern des Transistors und/oder eines anderen Mittels zum Erzeugen von elektrischem Strom ausgelegt sind, um den Wert dieser elektrischen Spannung zu modifizieren.

2. System nach Anspruch 1, bei dem die elektrischen Stromgeneratoren so konfiguriert sind, dass das an den Anschlüssen des Kondensators erzeugte trapezförmige Spannungssignal eine Interpolation des Riemann-Typs realisiert.

3. System nach einem der Ansprüche 1 bis 2, ferner **dadurch gekennzeichnet, dass** es auf einem selben Chip oder einer integrierten Schaltung oder einer anwendungsspezifischen integrierten Schaltung integriert ist.

4. System nach einem der Ansprüche 1 bis 3, ferner **dadurch gekennzeichnet, dass** der Kondensator (102) durch einen Kondensator eines Transistors gebildet wird, der zur Eingangsstufe eines Leistungsverstärkers gehört.

**Claims**

1. A system for generating an analogue signal comprising at least:

  - a set of at least two electric current generators (101),
  - at least one capacitor (102),
  - activation/deactivation means (103) for said electric current generators (101),
  - at least one transistor mounted in parallel with the capacitor and/or at least one other means of generating electric current mounted in series with the capacitor, and
- comparison means (402);

said electric current generators (101) being connected in parallel with one another, said capacitor (102) being connected in series with said electric current generators, said activation/deactivation means controlling said electric current generators (101) by means of a digital stream allowing control of the intensity of the electric current entering said capacitor (102) as a function of the signal to be generated, and generating a trapezoidal voltage signal at the terminals of said capacitor, said analogue signal being reconstructed through interpolation of said trapezoidal signal, said comparison means (402) being adapted to compare the value of an electric voltage at the terminals of said capacitor with a theoretical value (401) during the passage of the signal to be generated by known levels, and to control said transistor and/or other means of generating electric current in order to modify the value of this electric voltage.

2. The system according to claim 1, wherein electric current generators are configured such that said trapezoidal voltage signal generated at the terminals of the capacitor implements a Riemann-type interpolation.

3. The system according to any of claims 1 to 2, further **characterized in that** it is integrated into one and the same chip or an integrated circuit or an application-specific integrated circuit.

4. The system according to any of claims 1 to 3, further **characterized in that** said capacitor (102) is made up of a capacitor of a transistor belonging to the input stage of a power amplifier.

FIG.1

FIG.2

Information
de commande

Table de
correspondance

FIG.3

FIG.4

**EP 2 997 657 B1**

## RÉFÉRENCES CITÉES DANS LA DESCRIPTION

### Documents brevets cités dans la description

*   US 2006145902 A